# EUROPÄISCHE PATENTANMELDUNG

(11) **EP 0 831 333 A1**
(43) Veröffentlichungstag der Anmeldung: **25.03.1998**
(21) Anmeldenummer: 97113035.6
(22) Anmeldetag: 29.07.1997
(51) Int. Cl.: G01R 15/24, G02B 27/28, G02B 17/00

(54) **Anordnung zur Erzeugung eines mehreckigen Lichtstrahls einer bestimmten Polarisation**

(30) Priorität: 19.09.1996 DE 19638394
(71) Anmelder: SIEMENS AKTIENGESELLSCHAFT, 80333 München (DE)
(72) Erfinder: Bosselmann, Thomas, Dr., 91054 Erlangen (DE)

(57) **Zusammenfassung**

Die Anordnug erzeugt den mehreckigen Lichtstrahl (L) wie bisher mit Hilfe mehrerer aufeinandefolgender Strahlumlenkungseinrichtungen (1, 2, 3), jedoch besteht jede Strahlumlenkungseinrichtung (1, 2 bzw. 3) nicht wie bisher aus jeweils nur einer, sondern aus jeweils mindestens zwei aufeinanderfolgend angeordneten polarisationserhltenden Strahlumlenkeinheiten (10, 20, 30). Dadurch ist eine sehr vorteilhafte variable Gestaltung des Lichtstrahls (L) ermöglicht. Anwendung bei insbesondere magnetooptischen Sensoren zur Messung der Stromstärke eines in einem Leiter geführten elektrischen Stroms.

## Beschreibung

Die Erfindung betrifft eine Anordnung zur Erzeugung eines eine mehreckigen Lichtstrahls einer bestimmten Polarisation.

Eine Anordnung der genannten Art ist aus der EP-A-0088419 bekannt. Bei dieser bekannten Anordnung ist der in einem Glasring erzeugte mehreckige Lichtstrahl ein viereckiger Lichtstrahl der ein Rechteck beschreibt.

Dieser Lichtstrahl ist so erzeugt, daß in einem die bestimmte Polarisation aufweisenden Eingangslichtstrahl eine erste Strahlumlenkungseinrichtung angeordnet ist, die aus dem Eingangslichtstrahl einen gegenüber dem Eingangslichtstrahl um 90° umgelenkten ersten Ausgangslichtstrahl erzeugt, der die bestimmte Polarisation aufweist.

Im ersten Ausgangslichstrahl ist eine zweite Strahlumlenkungseinrichtung angeordnet, die aus dem ersten Ausgangslichtstrahl einen gegenüber dem ersten Ausgangslichtstrahl um 90° umgelenkten zweiten Ausgangslichtstrahl erzeugt, der die bestimmte Polarisation des ersten Ausgangslichtstrahls und Eingangslichtstrahls aufweist.

Entsprechend ist im zweiten Ausgangslichtsrahl eine dritte Strahlumlenkungseinrichtung angeordnet, die aus dem zweiten Ausgangslichtstrahl einen gegenüber dem zweiten Ausgangslichtstrahl um 90° umgelenkten dritten Ausgangslichtstrahl erzeugt, der die bestimmte Polarisation des ersten und zweiten Ausgangslichtstrahls und Eingangslichtstrahls aufweist, und im dritten Ausgangslichtsrahl eine vierte Strahlumlenkungseinrichtung, die aus dem dritten Ausgangslichtstrahl einen gegenüber dem dritten Ausgangslichtstrahl um 90° umgelenkten vierten Ausgangslichtstrahl erzeugt, der die bestimmte Polarisation des ersten, zweiten und dritten Ausgangslichtstrahls und Eingangslichtstrahls aufweist und den Eingangslichtstrahl kreuzt.

Jede Strahlumlenkungseinrichtung besteht jeweils aus einer einzelnen Strahlumlenkeinheit, die eine erste und zweite Reflexionsfläche aufweist, welche derart relativ zueinander angeordnet sind, daß die erste Reflexionsfläche beim schrägen Zuführen eines Lichtsrahls im Winkel von 45° zur ersten Reflexionsfläche einen zu diesem Lichtstrahl senkrechten ersten umgelenkten Lichtstrahl erzeugt, der schräg im Winkel von 45° auf die zweite Reflexionsfläche trifft, die relativ zur ersten Reflexionsfläche derart angeordnet ist, daß sie einen zu dem der die ersten Reflexionsfläche zugeführten Lichtsrahl und zum ersten umgelenkten Lichtstrahl jeweils senkrechten zweiten umgelenkten Lichtstrahl erzeugt.

Die Anordnung der zweiten Reflexionsfläche relativ zur ersten ist so, daß die zweite Reflexionsfläche um die Längsachse des von der ersten Reflexionsfläche erzeugten umgelenkten Lichtstrahls um 90° aus einer Stellung gedreht ist, in der sie parallel zur ersten Reflexionsfläche ist. Der von der zweiten Reflexionsfläche erzeugte umgelenkte Lichtstrahl breitet sich stets senkrecht zu dem der ersten Reflexionsfläche zugeführten Lichtstrahl aus.

Der ersten Reflexionsfläche der Strahlumlenkeinheit jeder Strahlumlenkungseinrichtung ist der Eingangslichtstrahl oder Ausgangslichtstrahl zugeführt, in welchem diese Strahlumlenkungseinrichtung angeordnet ist, und der von der zweiten Reflexionsfläche dieser Strahlumlenkeinheit erzeugte umgelenkte Lichtstrahl ist der von dieser Strahlumlenkungseinrichtung erzeugte Ausgangslichtstrahl. Jede Strahlumlenkungseinrichtung kann demnach nur einen umgelenkten Ausgangslichtstrahl erzeugen, dessen Ausbreitungsrichtung mit der Ausbreitungsrichtung des dieser Strahlumlenkungseinrichtung zugeführten Eingangs- oder Ausgangslichtstrahls einen Eckwinkel von 90° einschließt.

Der Erfindung liegt die Aufgabe zugrunde, eine Anordnung zur variablen Erzeugung eines eine bestimmte Polarisation aufweisenden mehreckigen Lichtstrahls bereitzustellen.

Diese Aufgabe wird durch die im Anspruch 1 angegebenen Merkmale gelöst.

Die Erfindung beruht auf der Erkenntnis, daß durch die Verwendung zweier oder mehrerer aufeinanderfolgender polarisationserhaltender Strahlumlenkeinheiten in einer einem Eckwinkel des Lichtstrahls zugeordneten erfindungsgemäßen Strahlumlenkungseinrichtung jeder beliebige Eckwinkel erhalten werden kann, wobei der Lichtstrahl vor und nach dem Eckwinkel die gleiche bestimmte Polarisation aufweist.

Dabei ist die erfindungsgemäße Anordnung vorteilhafterweise zur Erzeugung eines n-eckigen Lichtstrahls, der eine bestimmte Achse umgibt, geeignet, wobei sich der Eingangslichtstrahl und jeder von einer Strahlumlenkungseinrichtung erzeugte Ausgangslichtstrahl jeweils in einer Ausbreitungsrichtung quer zur Achse ausbreitet (Anspruch 2).

Bei der erfindungsgemäßen Anordnung können mit n Strahlumlenkungseinrichtungen n-eckige und, nach Anspruch 3, (n+1)-eckige erfindungsgemäße Lichtstrahlen erhalten werden, wobei n eine beliebige natürliche Zahl ≥ 2 ist.

Insbesondere sind dreieckige und viereckige erfindungsgemäße Lichtstrahlen realisierbar.

Vorteilhafterweise kann eine erfindungsgemäße Anordnung, insbesondere auch in der Ausbildung nach Anspruch 2 oder 3, so gestaltet sein, daß die Ausbreitungsrichtungen des Eingangslichtstrahls und der Ausgangslichtstrahlen sämtlicher Strahlumlenkungseinrichtungen jeweils parallel zu einer sämtlichen Strahlumlenkungseinrichtungen gemeinsamen Ebene sind, wobei jede Strahllängsachse, längs der sich ein von einer Strahlumlenkeinrichtung erzeugter zweiter umgelenkter Lichtstrahl ausbreitet und um welche die folgende Strahlumlenkeinheit drehbar ist, senkrecht zur gemeinsamen Ebene ist, und wobei der von der ausgangsseitigen Strahlumlenkeinheit jeder Strahlumlenkungseinrichtung erzeugte zweite umgelenkte Lichtstrahl parallel zur gemeinsamen Ebene ist (Anspruch 4).

Die erfindungsgemäßen mehreckigen Lichtstrahlen lassen sich vorteilhafterweise nicht nur nach ihrer Eckenzahl n oder n+1 unterscheiden, sondern es können vorteilhafterweise bei jedem mehreckigen, eine bestimmte Anzahl Ecken aufweisenden Lichtstrahl durch Zuordnung verschiedener Eckwinkel zu diesen Ecken zahlreiche, in bezug auf die Eckwinkel verschieden gestaltete erfindungsgemäße Lichtstrahlen der jeweils gleichen Eckenzahl realisiert werden. Die erfindungsgemäße Anordnung ermöglicht aus diesem Grunde vorteilhafterweise eine sehr variantenreiche Gestaltung der erfindungsgemäßen mehreckigen Lichtstrahlen.

Im allgemeinen liegen sich zwischen verschiedenen Paaren benachbarter Strahlumlenkungseinrichtungen ausbreitende Lichtstrahlen eines erfindungsgemäßen mehreckigen Lichtstrahls nicht in einer Ebene, sondern verlaufen parallel zu einer allen Strahlumlenkungseinrichtungen gemeinsamen Ebene in verschiedenen Abständen von dieser Ebene.

Die im Anspruch 5 angegebene Anordnung, bei der ein viereckiger Lichtstrahl realisiert ist, hat den Vorteil, daß der viereckige Lichtstrahl in einer allen drei Strahlumlenkungseinrichtungen gemeinsamen Ebene verläuft. Dazu weist erfindungsgemäß jede der drei Strahlumlenkungseinrichtungen nicht nur zwei, sondern drei aufeinanderfolgende polarisationserhaltende Strahlumlenkeinheiten auf.

Bei bestimmten Anwendungen einer erfindungsgemäßen Anordnung kann es zweckmäßig sein, wenn die allen Strahlumlenkungseinrichtungen gemeinsame Ebene senkrecht zur Achse ist (Anspruch 6). Dies ist beispielsweise bei einer nachfolgend beschriebenen Anwendung einer erfindungsgemäßen Anordnung in einem magnetooptischen Sensor zu Messung der Stromstärke eines in einem elektrischen Leiter geführten elektrischen Stroms günstig.

Bevorzugterweise ist bei einer erfindungsgemäßen Anordnung eine polarisationserhaltende Strahlumlenkeinheit nach Maßgabe des Anspruchs 7 ausgebildet. Eine Realisierung einer derart ausgebildeten polarisationserhaltenden Strahlumlenkeinheit ist aus IEEE Journal of Quantum Electronics, Vol. QE-2, No. 8, Seiten 255-259, Aug. 1966 bekannt. Eine bei der erfindungsgsemäßen Anordnung vorteilhaft anwendbare konkrete Realisierung einer solchen Strahlumlenkeinheit besteht aus zwei um 90° zueinander verdrehten optischen Prismen.

Bevorzugter- und vorteilhafterweise wird eine erfindungsgemäße Anordnung bei einem Sensor zur elektro- und magnetooptischen Messung eines in einem elektrischen Leiter geführten elektrischen Stroms und/oder einer am Leiter anliegenden elektrischen Spannung mit Hilfe eines den Leiter umgebenden und eine bestimmte Polarisation aufweisenden Lichtstrahls zur Erzeugung dieses umgebenden Lichtstrahls angewendet (Anspruch 8).

Die Erfindung wird in der nachfolgenden Beschreibung anhand der Figuren beispielhaft näher erläutert. Es zeigen:
- Figur 1: in schematischer Darstellung eine beispielhafte erfindungsgemäße Anordnung zur Erzeugung eines dreieckigen Lichtstrahls,
- Figur 2: in schematischer Darstellung einen Querschnitt durch ein Anwendungsbeispiel der Anordnung nach Figur 1,
- Figur 3: in schematischer Darstellung eine beispielhafte erfindungsgemäße Anordnung zur Erzeugung eines in einer Ebene verlaufenden viereckigen Lichtstrahls bestimmter Polarisation und
- Figur 4: in perspektivischer schematischer Darstellung eine mit zwei Prismen realisierte beispielhafte polarisationserhaltende Strahlumlenkeinheit, die bei den erfindungsgemäßen Anordnungen verwendbar ist.

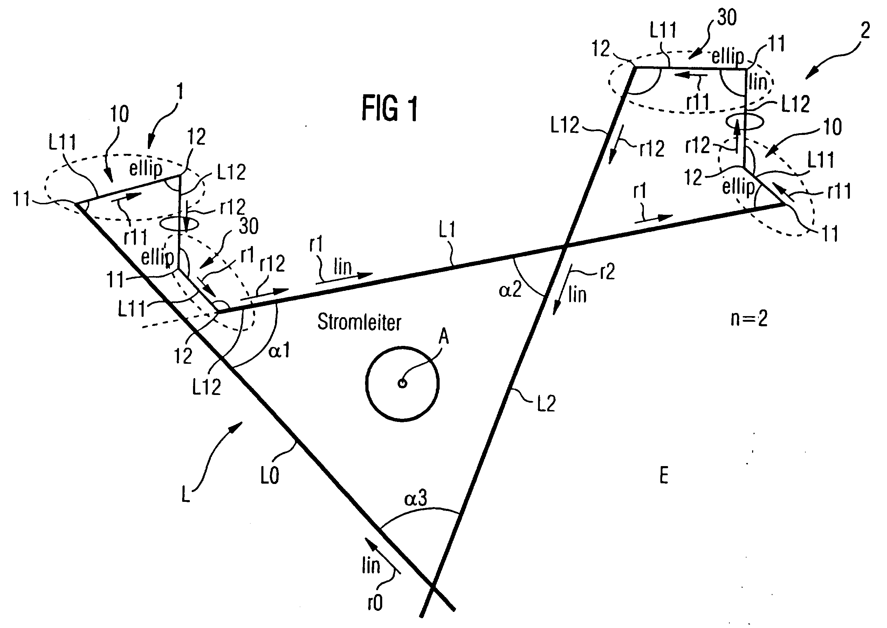

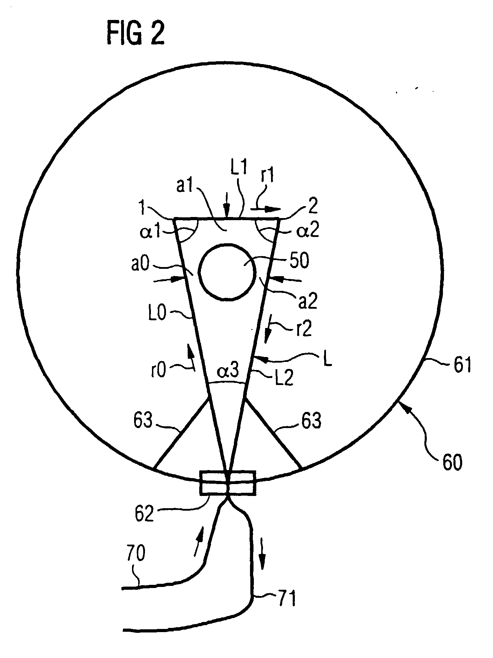

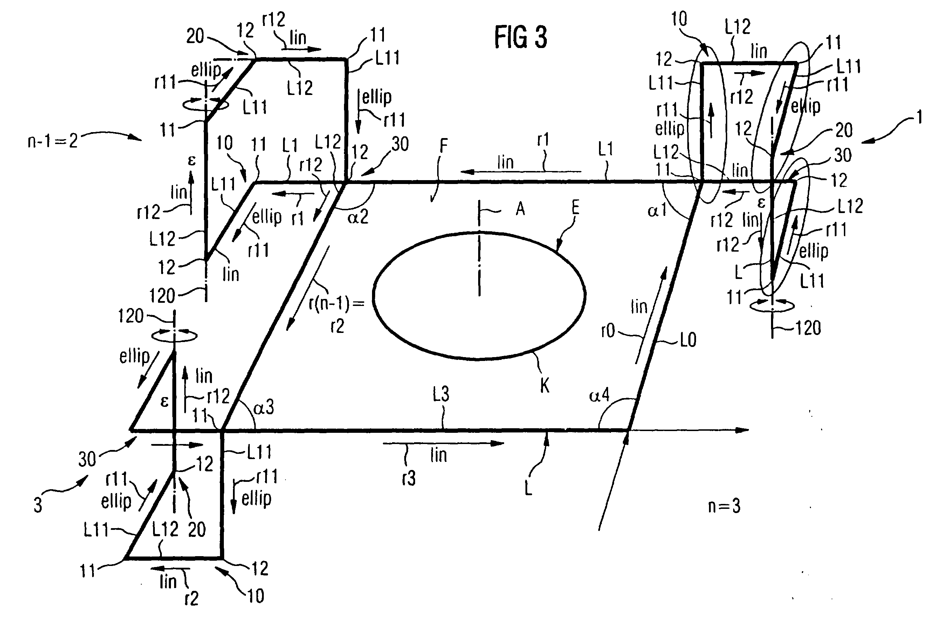

Der von der Anordnung nach den Figuren 1 und 2 erzeugte dreieckige Lichtstrahl L umgibt eine Achse A und ist ein (n+1)-eckiger Lichtstrahl, d.h., es gilt n = 2. Der von der Anordnung nach Figur 3 erzeugte und eine Achse (A) umgebende viereckige Lichtstrahl L ist ein (n+1)-eckiger Lichtstrahl, d.h., es gilt n = 3. Entsprechend weist die Anordnung nach den Figuren 1 und 2 eine erste und zweite Strahlumlenkungseinrichtung 1 bzw. 2 und die Anordnung nach Figur 3 eine erste, zweite und dritte Strahlumlenkungseinrichtung 1, 2 bzw. 3 auf.

Bei jeder dieser Anordnungen ist die erste Strahlumlenkungseinrichtung 1 in einem sich quer zur Achse A ausbreitenden Eingangslichtstrahl L0 der bestimmten, beispielsweise linearen Polarisation lin angeordnet und erzeugt einen ersten umgelenken Ausgangslichtstrahl L1, der die bestimmte lineare Polarisation lin aufweist und sich quer zur Achse A in einer Ausbreitungsrichtung r1 ausbreitet, die mit der Ausbreitungsrichtung r0 des Eingangslichtstrahls r0 einen der bestimmten, der ersten Strahlumlenkungseinrichtung 1 zugeordneten ersten Eckwinkel α1 einschließt.

Die folgende zweite Strahlumlenkungseinrichtung 2 ist in dem von der vorhergehenden ersten Strahlumlenkungseinrichtung 1 erzeugten Ausgangslichtstrahl L1 angeordnet und erzeugt einen weiteren umgelenkten Ausgangslichtstrahl L2, der ebenfalls die bestimmte lineare Polarisation lin aufweist und sich quer zur Achse A in einer Ausbreitungsrichtung r2 ausbreitet, die mit der Ausbreitungsrichtung r1 des von der vorhergehenden ersten Strahlumlenkungseinrichtung 1 erzeugten Ausgangslichtstrahls L1 einen bestimmten, dieser zweiten Strahlumlenkungseinrichtung 2 zugeordneten Eckwinkel α2 einschließt.

Bei der Anordnung nach den Figuren 1 und 2 ist diese zweite Strahlumlenkungseinrichtung 2 zugleich die letzte Strahlumlenkungseinrichtung.

Bei der Anordnung nach Figur 3 folgt auf die zweite Strahlumlenkungseinrichtung 2 noch die dritte und letzte Strahlumlenkungseinrichtung 3, die in dem von der vorhergehenden zweiten Strahlumlenkungseinrichtung 2 erzeugten Ausgangslichtstrahl L2 angeordnet ist und einen weiteren umgelenkten Ausgangslichtstrahl L3 erzeugt, der die bestimmte lineare Polarisation lin aufweist und sich quer zur Achse A in einer Ausbreitungsrichtung r3 ausbreitet, die mit der Ausbreitungsrichtung r2 des von der vorhergehenden zweiten Strahlumlenkungseinrichtung erzeugten Ausgangslichtstrahls L2 einen bestimmten, dieser dritten Strahlumlenkungseinrichtung 3 zugeordneten Eckwinkel α3 einschließt.

Bei der Anordnung nach den Figuren 1 un 2 besteht jede einzelne Strahlumlenkungseinrichtung 1 bzw. 2 jeweils aus zwei aufeinanderfolgenden polarisationserhaltenden Strahlumlenkeinheiten, einer eingangsseitigen Strahlumlenkeinheit 10 und einer ausgangsseitigen Strahlumlenkeinheit 30. Diese Strahlumlenkeinheiten 10 und 30 sind in der Figur 1 stark vergrößert dargestellt.

Die eingangsseitige Strahlumlenkeinheit 10 der ersten Strahlumlenkungseinrichtung 1 ist im Eingangslichtstrahl 10 angeordnet und erzeugt aus dem Eingangslichtstrahl 10 einen ersten umgelenkten Lichtstrahl L11, der sich senkrecht zum Eingangslichtstrahl L0 ausbreitet, und aus diesem ersten umgelenkten Lichtstrahl L11 einen zweiten umgelenkten Lichtstrahl L12, der sich sowohl senkrecht zum Eingangslichtstrahl L0 als auch senkrecht zu diesem ersten umgelenkten Lichtstrahl L11 ausbreitet, wobei der zweite umgelenkte Lichtstrahl L12 die lineare Polarisation lin des Eingangslichtstrahls L0 aufweist.

Die ausgangsseitige Strahlumlenkeinheit 30 dieser ersten Strahlumlenkungseinrichtung 1 ist in dem von der eingangsseitigen Strahlumlenkeinheit 10 erzeugten zweiten umgelenkten Lichtstrahl L12 angeordnet und erzeugt aus diesem zugeführten umgelenkten Lichtstrahl L12 einen ersten umgelenkten Lichtstrahl L11, der sich senkrecht zu diesem zugeführten umgelenkten Lichtstrahl L12 ausbreitet. Aus diesem erzeugten ersten umgelenkten Lichtstrahl L11 erzeugt die ausgangsseitige Strahlumlenkeinheit 30 einen zweiten umgelenkten Lichtstrahl L12, der sich sowohl senkrecht zu dem zugeführten dieser Strahlumlenkeinheit 30 als auch senkrecht zu dem vom dieser Strahlumlenkeinheit 30 erzeugten ersten umgelenkten Lichtstrahl L11 ausbreitet, wobei dieser zweite umgelenkte Lichtstrahl L12 die lineare Polarisation lin des von der eingangsseitigen Strahlumlenkeinheit 10 erzeugten zweiten umgelenkten Lichtstrahls L12 und damit des Eingangslichtstrahls L0 aufweist.

Der von der ausgangsseitigen Strahlumlenkeinheit 30 erzeugte zweite umgelenkte Lichtstrahl L12 bildet den von der ersten Strahlumlenkungseinrichtung 1 erzeugten Ausgangslichtsrahl L1 der bestimmten lineraren Polarisation lin, dessen Ausbreitungsrichtung r1 mit der Ausbreitungsrichtung r0 des Eingangslichtstrahls L0 den Eckwinkel α1 einschließt und in welchem die zweite Strahlumlenkungseinrichtung 2 angeordnet ist.

Die eingangsseitige Strahlumlenkeinheit 10 der zweiten Strahlumlenkungseinrichtung 2 ist im Ausgangslichtstrahl L1 angeordnet und erzeugt aus diesem Ausgangslichtstrahl L1 einen ersten umgelenkten Lichtstrahl L11, der sich senkrecht zu diesem Ausgangslichtstrahl L1 ausbreitet, und aus diesem ersten umgelenkten Lichtstrahl L11 einen zweiten umgelenkten Lichtstrahl L12, der sich sowohl senkrecht zu diesem Ausgangslichtstrahl L1 als auch senkrecht zu diesem ersten umgelenkten Lichtstrahl L11 ausbreitet, wobei der zweite umgelenkte Lichtstrahl L12 die lineare Polarisation lin des Ausgangslichtstrahls L1 und damit des Eingangslichtstrahls L0 aufweist.

Die ausgangsseitige Strahlumlenkeinheit 30 dieser zweiten Strahlumlenkungseinrichtung 2 ist in dem von der eingangsseitigen Strahlumlenkeinheit 10 dieser zweiten Strahlumlenkungseinrichtung 2 erzeugten zweiten umgelenkten Lichtstrahl L12 angeordnet und erzeugt aus diesem zugeführten umgelenkten Lichtstrahl L12 einen ersten umgelenkten Lichtstrahl L11, der sich senkrecht zu diesem zugeführten umgelenkten Lichtstrahl L12 ausbreitet. Aus diesem erzeugten ersten umgelenkten Lichtstrahl L11 erzeugt die ausgangsseitige Strahlumlenkeinheit 30 einen zweiten umgelenkten Lichtstrahl L12, der sich sowohl senkrecht zu dem dieser Strahlumlenkeinheit 30 zugeführten umgelenkten Lichtstrahl L12 als auch senkrecht zu dem vom dieser Strahlumlenkeinheit 30 erzeugten ersten umgelenkten Lichtstrahl L11 ausbreitet, wobei dieser zweite umgelenkte Lichtstrahl L12 die lineare Polarisation lin des von der eingangsseitigen Strahlumlenkeinheit 10 dieser zweiten Strahlumlenkungseinrichtung 2 erzeugten zweiten umgelenkten Lichtstrahls L12 und damit des dieser zweiten Strahlumlenkungseinrichtung 2 zugeführten Ausgangslichtstrahls L1 und des Eingangslichtstrahls L0 aufweist.

Der von der ausgangsseitigen Strahlumlenkeinheit 30 der dieser zweiten Strahlumlenkungseinrichtung 2 erzeugte zweite umgelenkte Lichtstrahl L12 bildet den von dieser zweiten Strahlumlenkungseinrichtung 2 erzeugten Ausgangslichtsrahl L2 der bestimmten lineraren Polarisation lin, dessen Ausbreitungsrichtung r2 mit der Ausbreitungsrichtung r1 des von der ersten Strahlumlenkungseinrichtung 1 erzeugten Ausgangslichtstrahls L1 den Eckwinkel α1 einschließt.

Jeder Strahlumlenkeinheit 10 bzw. 30 ist der dieser Strahlumlenkeinheit 10 bzw. 30 zugeführte Lichtstrahl in einer richtigen Ausbreitungsrichtung zuzuführen, damit diese Strahlumlenkeinheit 10 bzw. 30 den ersten und zweiten umgelenkten Lichtstrahl L11 bzw. L12 so erzeugt, daß sich der erste umgelenkte Lichtstrahl L11 senkrecht zum zugeführten Lichtstrahl und der zweite umgelenkte Lichtstrahl L12 sowohl senkrecht zum zugeführten Lichtstrahl als auch senkrecht zum ersten umgelenkten Lichtstrahl L11 ausbreitet.

Dies bedeutet, daß
- der Eingangslichtstrahl L0, in welchem die erste Strahlumlenkungseinrichtung 1 angeordnet ist, und die eingangsseitige Strahlumlenkeinheit 10 dieser ersten Strahlumlenkungseinrichtung 1 derart relativ zueinander angeordnet sind, daß die Ausbreitungsrichtung r0 des Eingangslichtstrahls L0 in bezug auf diese eingangsseitige Strahlumlenkeinheit 10 richtige Ausbreitungsrichtung ist,
- der von der ersten Strahlumlenkungseinrichtung 1 erzeugte Ausgangslichtstrahl L1, in welchem die zweite Strahlumlenkungseinrichtung 2 angeordnet ist, und die eingangsseitige Strahlumlenkeinheit 10 dieser zweiten Strahlumlenkungseinrichtung 2 derart relativ zueinander angeordnet sind, daß die Ausbreitungsrichtung r1 des Ausgangslichtstrahls L1 in bezug auf diese eingangsseitige Strahlumlenkeinheit 10 richtige Ausbreitungsrichtung ist und
- jede ausgangsseitige Strahlumlenkeinheit 30 derart in dem von der vorhergehenden eingangsseitigen Strahlumlenkeinheit 10 erzeugten zweiten umgelenkten Lichtstrahl L12 angeordnet ist, daß die Ausbreitungsrichtung r12 dieses zweiten umgelenkten Lichtstrahls L12 in bezug auf diese ausgangsseitige Strahlumlenkeinheit 30 richtige Ausbreitungsrichtung ist.

Die richtige Ausbreitungsrichtung hängt generell vom konkreten Aufbau der Strahlumlenkungseinrichtungen ab. Ein Beispiel für die richtige Ausbreitungsrichtung in bezug auf einen konkreten Aufbau einer Strahlumlenkungseinrichtung wird unten angegeben.

Bei jeder eingangsseitigen Strahlumlenkeinheit 10 weist der von ihr erzeugte zweite umgelenkte Lichtstrahl L12 eine Strahllängsachse 120 auf, längs der sich dieser umgelenkte Lichtstrahl L12 ausbreitet und um welche die folgende ausgangsseitige Strahlumlenkeinheit 30, der dieser umgelenkte Lichtstrahl L12 zugeführt ist, drehbar ist, ohne daß die richtige Ausbreitungsrichtung r12 dieses umgelenkten Lichtstrahls L12 in bezug auf die folgende ausgangsseitige Strahlumlenkeinheit 30 verlassen wird.

Dadurch ist es möglich, daß die ausgangsseitige Strahlumlenkeinheit 30 jeder Strahlumlenkungseinrichtung 1 bzw.2 einen zweiten umgelenkten Lichtstrahl L12 erzeugt, dessen Ausbreitungsrichtung r12 aufgrund der Drehbarkeit der ausgangsseitigen Strahlumlenkeinheit 30 um die Strahllängsachse 120 auf einen dieser Strahlumlenkungseinrichtung 1 bzw. 2 zugeordneten Eckwinkel α1 bzw. α2 einstellbar ist und der den Ausgangslichtstrahl L1 bzw. L2 dieser dieser Strahlumlenkungseinrichtung 1 bzw. 2 bildet.

Speziell ist es bei der Anordnung nach den Figuren 1 und 2 so eingerichtet, daß der dreieckige Lichtstrahl L eine bestimmte Achse A umgibt und sich der Eingangslichtstrahl L0 in der Ausbreitungsrichtung r0, der von der ersten Strahlumlenkungseinrichtung 1 erzeugte Ausgangslichtstrahl L1 in der Ausbreitungsrichtung r1 und der der von der zweiten Strahlumlenkungseinrichtung 2 erzeugte Ausgangslichtstrahl L2 in der Ausbreitungsrichtung r2 jeweils quer zur Achse A ausbreitet.

Überdies ist es bei der Anordnung nach den Figuren 1 und 2 speziell so eingerichtet, daß die Ausbreitungsrichtung r2 des von der zweiten und letzten Strahlumlenkungseinrichtung 2 erzeugten letzten umgelenkten Ausgangslichtstrahls L2 mit der Ausbreitungsrichtung r0 des Eingangslichtstrahls L0 einen zusätzlichen Eckwinkel α3 einschließt, wobei sich zudem der Eingangslichtstrahl L0 und der letzte umgelenkte Ausgangslichtstrahl L2 kreuzen, so daß der dreieckige Lichtstrahl L gewissermaßen ein Dreieck beschreibt.

Darüberhinaus ist es bei der Anordnung nach den Figuren 1 und 2 speziell so eingerichtet, daß
- die Ausbreitungsrichtung r0 des Eingangslichtstrahls L0 parallel zu einer beiden vorhandenen Strahlumlenkungseinrichtungen 1 und 2 gemeinsamen Ebene E ist,
- sowohl die Strahllängsachse 120, längs der sich der von der eingangsseitigen Strahlumlenkeinrichtung 10 der ersten Strahlumlenkungseinrichtung 1 erzeugte zweite umgelenkte Lichtstrahl L12 ausbreitet und um welche die ausgangseitige Strahlumlenkeinheit 30 dieser Strahlumlenkungseinrichtung 1 drehbar ist,
- als auch die Strahllängsachse 120, längs der sich der von der eingangsseitigen Strahlumlenkeinrichtung 10 der zweiten Strahlumlenkungseinrichtung 1 erzeugte zweite umgelenkte Lichtstrahl L12 ausbreitet und um welche die ausgangseitige Strahlumlenkeinheit 30 dieser Strahlumlenkungseinrichtung 2 drehbar ist,
- senkrecht zur gemeinsamen Ebene E sind und dadurch
- der von der ausgangsseitigen Strahlumlenkeinheit 30 jeder der beiden Strahlumlenkungseinrichtungen 1 und 2 erzeugte zweite umgelenkte Lichtstrahl L12 jeweils parallel zur gemeinsamen Ebene E ist, so daß
- die Ausbreitungsrichtungen r1 und r2 der beiden Ausgangslichtstrahlen L1 und L2 beider vorhandenen Strahlumlenkungseinrichtungen 1 und 2 zusammen mit der Ausbreitungsrichtung r0 des Eingangslichtstrahls L0 jeweils parallel zur gemeinsamen Ebene E sind.

Die gemeinsame Ebene E ist in den Figuren 1 und 2 die Zeichenebene. Speziell steht die Achse A senkrecht zur gemeinsamen Ebene E, so daß die zur gemeinsamen Ebene E senkrechten Strahllängsachsen 120 parallel und die zur gemeinsamen Ebene E parallelen Ausbreitungsrichtungen r0, r1 und r2 des eingangslichtstrahls L0 und der Ausgangslichtstrahlen L1, L2 jeweils senkrecht zur Achse A sind.

Der Eingangslichtstrahl L0 und der von der zweiten Strahlumklenkungseinrichtung 2 erzeugte Ausgangslichtstrahl L2 breiten sich beim Beispiel nach Figur 1 in der gleichen Ebene, beispielsweise der gemeinsamen Ebene E aus, während der von der ersten Strahlumklenkungseinrichtung 1 erzeugte Ausgangslichtstrahl L1 vertikal zu dieser Ebene um ε versetzt ist. Dieser Versatz ε ist gleich der Länge des von der eingangsseitigen Strahlumlenkeinheit 10 einer Strahlumlenkungseinrichtung 1 oder 2 erzeugten und sich entlang der Strahllängsachse 120 bis zur ausgangsseitigen Strahlumlenkeinheit 30 dieser Strahlumlenkungseinrichtung 1 oder 2 ausbreitenden zweiten umgelenkten Lichtstrahls L12.

Die Anordnung nach den Figuren 1 und 2 ist besonders für einen einen Sensor zur elektro- und/oder magnetooptischen Messung der Stromstärke eines in einem elektrischen Leiter geführten elektrischen Stroms mit Hilfe eines den Leiter umgebenden und eine bestimmte Polarisation aufweisenden Lichtstrahls zur Erzeugung dieses umgebenden Lichtstrahls geeignet.

Die in der EP-A-0088419 beschriebene Anordnung zur Erzeugung des viereckigen Lichtstrahls ist bereits für einen Sensor zur magnetooptischen Messung der Stromstärke eines in einem elektrischen Leiter geführten elektrischen Stroms mit Hilfe des den Leiter umgebenden viereckigen Lichtstrahls unter Ausnutzung des Faraday-Effekts verwendet.

Es wurde erkannt, daß für bestimmte Einbauformen eines solchen Sensors in Hochspannungsanlagen wie beispielsweise einer gasisolierten Schaltanlage ein erfindungsgemäßer dreieckiger Lichtstrahl L nach den Figuren 1 und 2 günstig ist, der den elektrischen Leiter umgibt.

Eine vorteilhafte derartige Einbauform ist in der Figur 2 schematisch dargestellt und betrifft einen gasisolierten stromführenden elektrischen Leiter 50, der in einem ein elektrisch isolierendes Gas enthaltenden Tank 60 angeordnet ist. Der Leiter 50 erstreckt sich senkrecht zur Zeichenebene und repräsentiert die Achse A in Figur 1.

In der Wand 61 des Tanks 60 ist ein optisches Fenster 62 ausgebildet, durch das Licht der bestimmten Polarisation in das Innere des Tanks 60 eingestrahlt werden kann. Dieses Licht wird durch das Fenster 62 in Form des Eingangslichtstrahls L0 eingestrahlt, der in der Ausbreitungsrichtung r0 in geringem Abstand a0 am Leiter 50 vorbeiläuft und danach auf die durch eine Ecke mit dem Eckwinkel α1 repräsentierte erste Strahlumlenkungseinrichtung 1 trifft, die aus diesem Eingangslichtstrahls L0 den um diesen Eckwinkel α1 umgelenkten und sich in der Ausbreitungsrichtund r1 ausbreitenden Ausgangslichtstrahl L1 erzeugt.

Dieser Ausgangslichtstrahl L1 läuft in geringem Abstand a1 am Leiter 50 vorbei und trifft danach auf die durch eine Ecke mit dem Eckwinkel α2 repräsentierte zweite Strahlumlenkungseinrichtung 2, die den um diesen Eckwinkel α2 umgelenkten Ausgangslichtstrahl L2 erzeugt, der sich in der Ausbreitungsrichtung a2 ausbreitet.

Dieser Ausgangslichtstrahl L2 läuft in geringem Abstand a2 am Leiter 50 vorbei und trifft, mit dem Eingangslichtstrahl L0 den Eckwinkel α3 einschließend, auf das Fenster 50, aus dem er aus dem Tank 60 auskoppelbar ist.

Der Eingangslichtstrahl L0 und die beiden Ausgangslichtstrahlen L1 und L2 bilden zusammen den ein schlankes Dreieck beschreibenden dreieckigen Lichtstrahl L, der den Leiter 60 eng umschließt. Die Eckwinkel α1 und α2 sind vorzugsweise gleich groß gewählt, so daß der Lichtstrahl L ein gleichschenkeliges Dreieck beschreibt.

Ist der Sensor ein magnetooptischer, der auf dem Faraday-Effekt beruht, muß sich der Lichtstrahl L in einem festenoptischen Medium, beispielsweise Glas, ausbreiten. Die Einbauform nach Figur 2 hat den Vorteil, daß dieses Medium an der Tankwand 61 , beispielsweise durch Stützer 63, auf Erdpotential gehaltert werden kann.

Das Fenster 62 kann eine nich dargestellte Polarisationsoptik aufweisen. Der Eingangslichtstrahl L0 kann durch einen Lichtwellenleiter 70, beispielsweise eine optische Faser, dem Fenster 62 zugeleitet und der Ausgangslichtstrahl L2 vom Fenster 62 fortgeleitet sein.

Wie schon erwähnt breiten sich bei der Anordnung nach der EP-A-0088419 und auch bei der Anordnung nach den Figuren 1 und 2 der Eingangslichtstrahl und die Ausgangslichtstrahlen des mehreckigen Lichtstrahls nicht in einer gemeinsamen Ebene, sondern in gegeneinander versetzten parallelen Ebenen aus, wobei Bestandteil dieses des mehreckigen Lichtstrahls genaugenommen auch die sich senkrecht zu diesen Ebenen ausbreitenden Lichtstrahlen innerhalb der Strahlumlenkungseinrichtungen sind, die bei der Anordnung nach der EP-A-0088419 die ersten umgelenkten Lichtstrahlen, bei der Anordnung nach Figur 1 die von der eingangsseitigen Strahlumlenkeinheit 10 erzeugten zweiten umgelenkten Lichtstrahlen L12 mit der Strahllängsachse 120 sind.

Wird dieser mehreckige Lichtstrahl bei einem auf dem Faraday-Effekt beruhenden magnetooptischen Sensor angewendet, tragen diese sich senkrecht zu den Ebenen ausbreitenden Lichtstrahlen nicht zur Faradayrotation bei und stören nicht, solange die die vom Strom im elektrischen Leiter erzeugten Magnetfeldlinien senkrecht zur Ausbreitungsrichtung dieser Lichtstrahlen verlaufen. Ist dies jedoch nicht der Fall, beispielsweise weil die Ebenen nicht genau senkrecht sondern verkippt zur Achse des Leiters angeordnet sind, können diese Lichtstrahlen zur Faradayrotation beitragen und die Messung stören.

Aus diesem Grunde ist ein mehreckiger Lichtstrahl günstig, bei dem sich der Eingangslichtstrahl und die Ausgangslichtstrahlen in einer gemeinsamen Ebene ausbreiten.

Die in der Figur 3 schematisch perspektivisch dargestellte erfindungsgemäße Anordnung leistet dies in bezug auf eine gemeinsame Ebene E, die den Kreis K mit der zentralen Achse A enthält.

Diese Anordnung besteht wie die Anordnung nach der EP-A-0088419 aus drei Strahlumlenkungseinrichtungen 1, 2 und 3, denen diese Ebene E gemeinsam ist und in der sich im Unterschied zur bekannten Anordnung der Eingangslichtstrahl L0 und die von diesen drei Strahlumlenkungseinrichtungen 1, 2 und 3 erzeugten Ausgangslichtstrahlen L1, L2 bzw. L3 ausbreiten sollen.

Dazu besteht im Unterschied zu dieser bekannten Anordnung und zur Anordnung nach den Figuren 1 und 2 jede der drei Strahlumlenkungseinrichtungen 1, 2 und 3 jeweils aus drei polarisationserhaltenden Strahlumlenkeinheiten - der eingangsseitigen Strahlumlenkeinheit 10 und ausgangsseitigen Strahlumlenkeinheit 30 nach Figur 1 und einer zwischen der eingangsseitigen und ausgangsseitigen Strahlumlenkeinheit 10 bzw. 30 angeordneten weiteren Strahlumlenkeinheit 20.

Die erste Strahlumlenkungseinrichtung 1 ist im Eingangslichtstrahl L0 der bestimmten Polarisation angeordnet und erzeugt aus diesem Eingangslichtstrahl L0 den diese Polarisation lin aufweisenden ersten umgelenkten Ausgangslichtstrahl L1, dessen Ausbreitungsrichtung r1 mit der Ausbreitungsrichtung r0 des Eingangslichtstrahls L0 den Eckwinkel α1 = 90° einschließt. Im ersten Ausgangslichtstrahl L1 ist die zweite Strahlumlenkungseinrichtung 2 angeordnet und erzeugt aus diesem Ausgangslichtstrahl L1 den die bestimmte Polarisation aufweisenden zweiten umgelenkten Ausgangslichtstrahl L2, dessen Ausbreitungsrichtung r2 mit der Ausbreitungsrichtung r1 des ersten Ausgangslichtstrahls L1 den Eckwinkel α2 = 90° einschließt. Die dritte Strahlumlenkungseinrichtung 3 ist im zweiten Ausgangslichtstrahl L2 angeordnet und erzeugt aus diesem Ausgangslichtstrahl L2 den die bestimmte Polarisation aufweisenden dritten umgelenkten Ausgangslichtstrahl L3, dessen Ausbreitungsrichtung r3 mit der Ausbreitungsrichtung r2 des zweiten Ausgangslichtstrahls L2 den Eckwinkel α1 = 90° und mit der Ausbreitungsrichtung r0 des Eingangslichtstrahls L0 den zusätzlichen Eckwinkel α4 = 90° einschließt.

Der eingangsseitigen Strahlumlenkeinheit 10 der ersten Strahlumlenkungseinrichtung 1 ist der Eingangslichtstrahl L0 derart zugeführt, daß die Ausbreitungsrichtung r0 des Eingangslichtstrahls L0 in bezug auf diese eingangsseitige Strahlumlenkeinheit 10 richtige Ausbreitungsrichtung ist. Der eingangsseitigen Strahlumlenkeinheit 10 der zweiten Strahlumlenkungseinrichtung 2 ist der von der ersten Strahlumlenkungseinrichtung 1 erzeugte Ausgangslichtstrahl L1 derart zugeführt, daß die Ausbreitungsrichtung r1 dieses Ausgangslichtstrahls L1 in bezug auf diese eingangsseitige Strahlumlenkeinheit 10 richtige Ausbreitungsrichtung ist. Schließlich ist der eingangsseitigen Strahlumlenkeinheit 10 der dritten Strahlumlenkungseinrichtung 3 der von der zweiten Strahlumlenkungseinrichtung 2 erzeugte Ausgangslichtstrahl L2 derart zugeführt, daß die Ausbreitungsrichtung r2 dieses Ausgangslichtstrahls L2 in bezug auf diese eingangsseitige Strahlumlenkeinheit 10 richtige Ausbreitungsrichtung ist.

Jede dieser drei eingangsseitigen Strahlumlenkeinheiten 10 erzeugt wie jede eingangsseitige Strahlumlenkeinheit 10 der Anordnung nach Figur 1 aus dem zugeführten Eingangslichtstrahl L0 oder Ausgangslichtstrahl L1 oder L2 den ersten umgelenkten Lichtstrahl L11, dessen Ausbreitungsrichtung r11 senkrecht zur Ausbreitungsrichtung r0, r1 oder r2 des dieser eingangsseitigen Strahlumlenkeinheiten 10 zugeführten Lichtstrahl L0, L1 bzw. L2 ist, und aus dem ersten umgelenkten Lichtstrahl L11 den zweiten umgelenkten Lichtstrahl L12, dessen Ausbreitungsrichtung r12 senkrecht zur Ausbreitungsrichtung r11 des ersten umgelenkten Lichtstrahls L11 und senkrecht zur Ausbreitungsrichtung r0, r1 oder r2 des dieser eingangsseitigen Strahlumlenkeinheiten 10 zugeführten Lichtstrahl L0, L1 bzw. L2 ist.

Die weitere Strahlumlenkeinheit 20 jeder der drei Strahlumlenkungseinrichtungen 1, 2 und 3 ist derart in dem von der eingangsseitigen Strahlumlenkeinheit 10 dieser Strahlumlenkungseinrichtungen 1, 2 bzw. 3 erzeugten zweiten umgelenkten Lichtstrahl L12 angeordnet, daß die Ausbreitungsrichtung r12 dieses zweiten umgelenkten Lichtstrahls L12 in bezug auf die weitere Strahlumlenkeinheit 20 richtige Ausbreitungsrichtung ist. Aus dem von der eingangsseitigen Strahlumlenkeinheit 10 erzeugten zweiten umgelenkten Lichtstrahl L12 erzeugt die weitere Strahlumlenkeinheit 20 einen ersten umgelenkten Lichtstrahl L11, dessen Ausbreitungsrichtung r11 senkrecht zur Ausbreitungsrichtung r12 des von der eingangsseitigen Strahlumlenkeinheit 10 erzeugten zweiten umgelenkten Lichtstrahls L12 ist, und aus diesem erzeugten ersten umgelenkten Lichtstrahl L11 einen zweiten umgelenkten Lichtstrahl L12, dessen Ausbreitungsrichtung r12 sowohl senkrecht zur Ausbreitungsrichtung r11 dieses ersten umgelenkten Lichtstrahls L11 als auch senkrecht zur Ausbreitungsrichtung r12 des von der eingangsseitigen Strahlumlenkeinheit 10 erzeugten zweiten umgelenkten Lichtstrahls L12 ist.

Der von der weiteren Strahlumlenkeinheit 20 jeder Strahlumlenkungseinrichtung 1, 2 bzw. 3 erzeugte zweite umgelenkte Lichtstrahl L12 ist der ausgangsseitigen Strahlumlenkeinheit 30 dieser Strahlumlenkungseinrichtung 1, 2 bzw. 3 derart zugeführt, daß die Ausbreitungsrichtung r12 dieses zweiten umgelenkten Lichtstrahls L12 in bezug auf diese ausgangsseitige Strahlumlenkeinheit 30 richtige Ausbreitunsrichtung ist. Aus diesem zweiten umgelenkten Lichtstrahl L12 erzeugt die ausgangsseitige Strahlumlenkeinheit 30 einen ersten umgelenkten Lichtstrahl L11, dessen Ausbreitungsrichtung r11 senkrecht zur Ausbreitungsrichtung dieses zweiten umgelenkten Lichtstrahls L12 ist, und aus diesem erzeugten ersten umgelenkten Lichtstrahl L11 einen zweiten umgelenkten Lichtstrahl L12, dessen Ausbreitungsrichtung r12 sowohl senkrecht zur Ausbreitungsrichtung r11 dieses ersten umgelenkten Lichtstrahls L11 als auch senkrecht zur Ausbreitungsrichtung r12 des von der weiteren Strahlumlenkeinheit 20 erzeugten zweiten umgelenkten Lichtstrahls L12 ist.

Der von jeder Strahlumlenkeinheit 10, 20 bzw. 30 erzeugte zweite umgelenkte Lichtstrahl L12 weist die bestimmte Polarisation des dieser Strahlumlenkeinheit 10, 20 bzw. 30 zugeführten Lichtstrahls, im Fall der Einheit 10 des zugeführten Eingangslichtstrahls L0 oder Ausgangslichtstrahls L1 bzw. L2 und im Fall der Einheiten 20 und 30 des zugeführten zweiten umgelenkten Lichtstrahls L12, auf.

Die Aufeinanderfolge der Ausbreitungsrichtungen r11 und r12 der ersten und zweiten umgelenkten Lichtstrahlen L11 und L12 ist in jeder Strahlumlenkungseinrichtung 1, 2 bzw. 3 so gewählt, daß der von der ausgangsseitigen Strahlumlenkeinheit 30 dieser Strahlumlenkungseinrichtung 1, 2 bzw. 3 erzeugte zweite umgelenkte Lichtstrahl L12, der den Ausgangslichtstrahl L1, L2 bzw. L3 dieser Strahlumlenkungseinrichtung 1, 2 bzw. 3 bildet, eine zur gemeinsamen Ebene E parallele Ausbreitungsrichtung r12 aufweist, welche die Ausbreitungsrichtung r1, r2 bzw. r3 dieses Ausgangslichtstrahls L1, L2 bzw. L3 ist.

In jeder dieser drei Strahlumlenkungseinrichtungen 1, 2 und 3 erzeugt jeweils eine von der ausgangsseitigen Strahlumlenkeinheit 30 verschiedene Strahlumlenkeinheit ähnlich wie die eingangseitige Strahlumlenkeinheit 10 nach Figur 1 den zweiten umgelenkten Lichtstrahl L12 mit der zur gemeinsamen Ebene E senkrechten Strahllängsachse 120, längs der sich dieser zweite umgelenkte Lichtstrahl L12 ausbreitet und um welche die folgende Strahlumlenkeinheit drehbar ist.

Nach Figur 3 wird beispielsweise dieser zweite umgelenkte Lichtstrahl L12 mit der zur gemeinsamen Ebene E senkrechten Strahllängsachse 120 in der ersten Strahlumlenkungseinrichtung 1 von der weiteren Strahlumlenkeinheit 20, in der zweiten Strahlumlenkungseinrichtung 2 von der eingangsseitigen Strahlumlenkeinheit 10 und in der dritten Strahlumlenkungseinrichtung 3 wiederum von der weiteren Strahlumlenkeinheit 20 erzeugt.

Außerdem erzeugt in jeder dieser drei Strahlumlenkungseinrichtungen 1, 2 und 3 jeweils eine der beiden Strahlumlenkeinheiten, die von der den zweiten umgelenkten Lichtstrahl L12 mit der zur gemeinsamen Ebene E senkrechten Strahllängsachse 120 erzeugenden Strahlumlenkeinheit verschieden sind, einen ersten umgelenkten Lichtstrahl L11 mit einer zu dieser gemeinsamen Ebene E senkrechten Ausbreitungsrichtung r11, die zur Ausbreitungsrichtung r12 des zweiten umgelenkten Lichtstrahls L12 mit der zur gemeinsamen Ebene E senkrechten Strahllängsachse 120 entgegengesetzt ist.

Nach Figur 3 wird beispielsweise dieser erste umgelenkte Lichtstrahl L11 mit der zur Ausbreitungsrichtung r12 des zweiten umgelenkten Lichtstrahls L12 mit der Strahllängsachse 120 entgegengesetzten Ausbreitungsrichtung r11 in der ersten Strahlumlenkungseinrichtung 1 von der eingangsseitigen Strahlumlenkungseinheit 10, in der zweiten Strahlumlenkungseinrichtung 2 von der ausgangsseitigen Strahlumlenkeinheit 30 und in der dritten Strahlumlenkungseinrichtung 3 wiederum von der eingangsseitigen Strahlumlenkeinheit 10 erzeugt.

Dieser erste umgelenkte Lichtstrahl L11 mit der zur Ausbreitungsrichtung r12 des zweiten umgelenkten Lichtstrahls L12 mit der Strahllängsachse 120 entgegengesetzten Ausbreitungsrichtung r11 ermöglicht in jeder der drei Strahlumlenkungseinrichtung 1, 2 und 3 die Kompensation des durch den zweiten umgelenkten Lichtstrahl L12 mit der Strahllängsachse 120 senkrecht zur gemeinsamen Ebene E bewirkten Versatzes ε des von der ausgangsseitigen Strahlumlenkeinheit 30 erzeugten und zu dieser Ebene E parallelen zweiten umgelenkten Lichtsstrahls L12 dieser Strahlumlenkungseinrichtung 1, 2 bzw. 3, so daß sich dieser zweite umgelenkte Lichtsstrahl L12, der den Ausgangangslichtstrahl L1, L2 bzw. L3 dieser Strahlumlenkungseinrichtung 1, 2 bzw. 3 bildet, in der gemeinsamen Ebene E ausbreitet.

Dadurch ist erreicht, daß sich der Eingangslichtstrahl L0 und die drei Ausgangslichtstrahlen L1, L2 und L3 in der gemeinsamen Ebene E ausbreiten und einen ebenen viereckigen Lichtstrahl L der bestimmten Polarisation, beispielsweise der Polarisation lin bilden.

Ein Vorteil der Anordnung nach Figur 3 ist darin zu sehen, daß die drei Strahlumlenkungseinrichtungen 1, 2 und 3 außerhalb der vom viereckigen Lichtstrahl L umschlossenen Fläche F angeordnet sind und gewissermaßen äußere Satelliten zu diesem Lichtstrahl L bilden.

Bei Anwendung dieses Lichtstrahls L in einem magnetooptischen Sensor zur Strommessung auf der Basis des Faraday-Effekts, bei welchem der linear polarisierte viereckige Lichtstrahl L den durch die zur Ebene E senkrechte Achse A in Figur 3 repräsentierten stromführenden Leiter umgibt, kann sichergestellt werden, daß die für die Faradayrotation relevanten und wichtigen Lichtstrahlen die Fläche F in der Ebene E umschließen. Um diese Fläche F sind die Lichtstrahlenverläufe in den drei Strahlumlenkungseinrichtungen 1 bis 3 gruppiert, die jeweils für sich eine Faradayrotation erzeugen können, doch messen sie keinen Strom, da kein Strom durch sie hindurchfließt.

Es besteht jedoch eine gewisse Störempfindlichkeit, da innerhalb jedes Lichtstrahlenverlaufs in den drei Strahlumlenkungseinrichtungen 1 bis 3 die bestimmte Polarisation streckenweise nicht erhalten bleibt. Da sie jedoch außerhalb des für die Strommessung benötigten Bereichs liegen, sind Maßnahmen zur Reduzierung der Störempfindlichkeit möglich. Einesteils lassen sich die Lichtstrahlenverläufe durch mikrooptische Bauteile auf sehr kleinem Raum realisieren, andernteils ist eine magnetische Schirmung möglich, wobei beides ohne Beeinträchtigung des Faraday-Meßbereichs erfolgen kann.

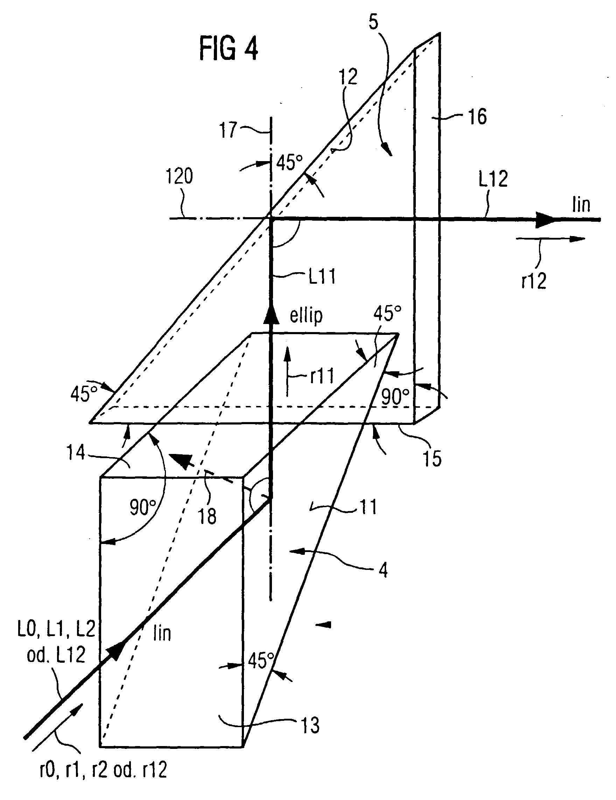

Eine bei den erfindungsgemäßen Anordnungen verwendete Strahlumlenkeinheit 10, 20 und/oder 30 kann gemäß Figur 4 so aufgebaut sein, daß sie jeweils eine erste und zweite Reflexionsfläche 11 bzw. 12 aufweist. Diese Reflexionsflächen 11 und 12 sind derart relativ zueinander angeordnet, daß die erste Reflexionsfläche 11 beim Zuführen eines Lichtsrahls L0, L1, L2 oder L12 in der richtigen Ausbreitungsrichtung r0, r1, r2 bzw. r12 den ersten umgelenkten Lichtstrahl L11 erzeugt, dessen Ausbreitungsrichtung r11 senkrecht zur Ausbreitungsrichtung r0, r1, r2 bzw. r12 des zugeführten Lichtstrahls L0, L1, L2 oder L12 ist. In diesem ersten umgelenkten Lichtstrahl ist die zweite Reflexionsfläche 12 angeordnet, die aus dem ersten umgelenkten Lichtstrahl L11 den zweiten umgelenkten Lichtstrahl L12 erzeugt, dessen Ausbreitungsrichtung r12 senkrecht zur Ausbreitungsrichtung r0, r1, r2 bzw. r12 des der ersten Reflexionsfläche 11 zugeführten Lichtsrahls L0, L1, L2 bzw. L12 und senkrecht zur Ausbreitungsrichtung r11 des ersten umgelenkten Lichtstrahls L11 ist.

In den Figuren 1 und 3 sind die Reflexionsflächen 11 und 12 jeweils vereinfacht durch Ecken dargestellt, in denen ein Lichtstrahl durch Umlenkung in einen anderen Lichtstrahl übergeht.

Die beiden Reflexionsflächen 11 und 12 sind auf einer gemeinsamen Achse 17 jeweils schräg in einem Winkel von 45° zu dieser Achse 17 geneigt angeordnet, wobei die Anordnung der zweiten Reflexionsfläche 12 relativ zur ersten Reflexionsfläche 11 so ist, daß die zweite Reflexionsfläche 12 um die gemeinsame Achse 17 um 90° aus einer Stellung gedreht ist, in der die zweite Reflexionsfläche 12 parallel zur ersten Reflexionsfläche 11 ist.

Ein dieser Strahlumlenkeinheit zugeführter Lichtstrahl L0, L1, L2 oder L12 ist in der richtigen Ausbreitungsrichtung zugeführt, wenn seine Ausbreitungsrichtung r0, r1, r2 bzw. r12 parallel zu einer von der Flächennormalen 18 der ersten Reflexionsfläche 11 und der Achse 17 aufgespannten Ebene im Winkel von 45° zur ersten Reflexionsfläche 11 ist. In diesem Fall wird der der ersten Reflexionsfläche 11 zugeführte Lichtstrahl L0, L1, L2 oder L12 senkrecht zur Achse 17 zugeführt und der von dieser Fläche 11 reflektierte und um 90° umgelenkte erste Lichtstrahl L11 breitet sich längs der Achse 17 aus, bis er auf die zweite Reflexionsfläche 12 trifft. Der von der zweiten Reflexionsfläche 12 reflektierte und um 90° umgelenkte zweite Lichtstrahl L11 breitet sich senkrecht zum zugeführten Lichtstrahl L0, L1, L2 oder L12 aus.

Weist der zugeführte Lichtstrahl L0, L1, L2 oder L12 die lineare Polarisation lin auf, so ist der erste umgelenkte Lichtstrahl L11 nicht mehr linear polarisiert, sondern weist elliptische Polarisation ellip auf. Der zweite umgelenkte Lichtstrahl L12 weist dagegen wieder die lineare Polarisation lin des zugeführte Lichtstrahls L0, L1, L2 oder L12 auf. In den Figuren 1 und 3 sind neben den zusätzlich mit lin gekennzeichneten Lichtstrahlen der linearen Polarisation lin auch die elliptisch polarisierten Lichtstahlen L11 zusätzlich mit ellip bezeichnet.

Die Ausführungsform nach Figur 4 einer Strahlumlenkeinheit 10, 20 und/oder 30 ist vorteilhafterweise mit zwei auf der Achse 17 angeordneten und um 90° relativ zueinander verdrehten optischen Prismen 4 und 5 aus optisch transparenten Material, beispielsweise Glas, realisiert. Das Prisma 4 weist eine Eintrittsfläche 13, die im Winkel von 45° zur Eintrittsfläche 13 stehende erste Reflexionsfläche 11 und eine im Winkel von 45° zur ersten Reflexionsfläche 11 und im Winkel von 90° zur Eintrittsfläche 13 stehende Austrittsfläche 14 auf. Der der ersten Reflexionsfläche 11 zuzführende Lichtstrahl L0, L1, L2 oder L12 tritt senkrecht durch die Eintrittsfläche 13 in das Prisma 4 ein und wird an der ersten Reflexionsfläche 11 durch Reflexion in den ersten umgelenkten Lichtstrahl L11 umgewandelt, der senkrecht durch die Austrittsfläche 14 aus dem Prisma 4 wieder austritt.

Der Austrittsfläche 14 des Prismas 4 liegt eine Eintrittsfläche 15 des Prismas 5 gegenüber, zu der eine senkrecht zur ersten Reflexionsfläche 11 des Prismas 4 geneigte zweite Reflexionsfläche 12 des Prismas 5 im Winkel von 45° steht. Eine Austrittsfläche 16 des Prismas 5 steht im Winkel von 45° zur zweiten Reflexionsfläche 12 und im Winkel von 90° zur Eintrittsfläche 15. Der aus Austrittsfläche 14 des Prismas 4 austretende erste umgelenkte Lichtstrahl L11 tritt senkrecht durch die Eintrittsfläche 15 in das Prisma 5 ein und wird an der zweiten Reflexionsfläche 12 durch Reflexion in den zweiten umgelenkten Lichtstrahl L12 umgewandelt, der senkrecht durch die Austrittsfläche 16 aus dem Prisma 5 wieder austritt.

Im zweiten umgelenkten Lichtstrahl L12 kann eine nächste aus einem Prisma 4 und Prisma 5 gebildete Strahlumlenkeinheit usw. angeordnet sein, derart daß die Eintrittsfläche 13 des Prismas 4 der nächsten Strahlumlenkeinheit der Austrittsfläche 16 des Prismas 5 der vorhergehenden Strahlumlenkeinheit gegenüberliegt und der aus der Austrittsfläche 16 dieses Prismas 5 austretende zweite umgelenkte Lichtstrahl L12 senkrecht durch die Eintrittsfläche 13 des Prismas 4 der nächsten Strahlumlenkeinheit in dieses Prisma 4 eintritt.

Diese nächste Strahlumlenkeinheit kann um die Längsachse 120 des zugeführten zweiten umgelenkten Lichtstrahls L12 beliebig verdreht werden, ohne daß sich ihre polarisationserhaltende Eigenschaft ändert. Ist die nächste Strahlumlenkeinheit ausgangsseitige Strahlumlenkeinheit einer Strahlumlenkungseinrichtung 1, 2 oder 3, so bildet der senkrecht aus der Austrittsfläche 16 ihres Prismas 5 austretende zweite umgelenkte Lichtstrahl L12 den Ausgangslichtstrahl L1, L2 bzw. L3 dieser einer Strahlumlenkungseinrichtung 1, 2 bzw. 3.

Die mit zwei Prismen 4 und 5 gebildeten Strahlumlenkeinheiten 10, 20 und/oder 30 ermöglichen sehr kompakte Strahlumlenkungseinrichtungen 1, 2 und/oder 3, die zudem miniaturisiert werden können. Dadurch können in den Strahlumlenkungseinrichtungen störanfällige Lichtstrahlen die nicht die bestimmte Polarisation aufweisen und/oder sich senkrecht zu einer Umlaufsrichtung des erzeugten mehreckigen Lichtstrahls L sehr kurz und dadurch weitgehend unschädlich gemacht werden.

Bei der Anordnung nach Figur 3 kann jede der drei Strahlumlenkungseinrichtungen 1, 2 und 3 mittels sechs kleiner Prismen 4, 5 realisiert werden. Der eigentliche Faraday-Meßbereich kann sich beispielsweise in einem quaderförmigen Glasblock mit einem kreisförmigen, beispielsweise durch den Kreis K in Figur 3 definierten Loch befinden, das der sich im Block ausbreitende viereckige Lichtstrahl L umgibt. Die Strahlumlenkungseinrichtungen 1, 2 und 3 können außen an den Block angeklebt sein. Eine Dachkantenprismenschleiferei am Block kann entfallen, so daß der Block vorteilhafterweise kostengünstiger herstellbar ist.

Die Auswertung des im mehreckigen Lichtstrahl L umlaufenden und von dem den Leiter umgebenden elektromagnetischen Feld beeiflußten Lichts kann auf jede herkömmliche Art erfolgen. Beispielsweise kann das Licht des von der letzten Strahlumlenkungseinrichtung 2 in Figur 1 und 2 oder 3 in Figur 3 erzeugten Ausgangslichtstrahls L2 bzw. L3 in zwei Anteile aufgespalten werden, um beispielsweise eine Temperaturkompensation vornehmen zu können.

Eine Anwendung der Erfindung ist in Verbindung mit einem magnetooptischen Sensor zur Messung der Stromstärke eines in einem Leiter 50 fließenden elektrischen Stroms beispielhaft beschrieben worden. Sie kann alternativ oder zusätzlich bei einem elektrooptischen Sensor zum Messen einer am Leiter 50 anliegenden elektrischen Spannung, beispielsweise eine Wechselspannung, sinngemäß angewendet werden. In diesem Fall wertet der Sensor das von dem von der Spannung erzeugten elektrischen oder elektromagnetischen Feld, beispielsweise aufgrund des Pockels-Effekts, beeinflußte Licht aus.

## Patentansprüche

1. Anordnung zur Erzeugung eines eine eine bestimmte Polarisation (lin) aufweisenden n-eckigen Lichtstrahls (L), wobei n eine natürliche Zahl ≥ 2 ist, bestehend aus
- einer ersten bis n-ten Strahlumlenkungseinrichtung (1, 2, ...n),
- deren erste (1) in einem Eingangslichtstrahl (L0) der bestimmten Polarisation (lin) angeordnet ist und einen ersten umgelenkten Ausgangslichtstrahl (L1) erzeugt, der die bestimmte Polarisation (lin) aufweist und sich in Ausbreitungsrichtung (r1) ausbreitet, die mit der Ausbreitungsrichtung (r0) des Eingangslichtstrahls (L0) einen bestimmten, der ersten Strahlumlenkungseinrichtung (1) zugeordneten ersten Eckwinkel (α1) einschließt, und
- deren jede folgende (2, 3, ... bzw. n) in einem von der vorhergehenden Strahlumlenkungseinrichtung (1, 2, ...bzw. (n-1)) erzeugten und die bestimmte Polarisation (lin) aufweisenden umgelenkten Ausgangslichtstrahl (L1, ... bzw. L(n-1)) angeordnet ist und je einen weiteren umgelenkten Ausgangslichtstrahl (L2, ... bzw. Ln) erzeugt, der die bestimmte Polarisation (lin) aufweist und sich in einer Ausbreitungsrichtung (r2, r3, ... bzw. rn) ausbreitet, die mit der Ausbreitungsrichtung (r1, r2, ... bzw. r(n-1))) des von der vorhergehenden Strahlumlenkungseinrichtung (1, 2, ...bzw. (n-1)) erzeugten Ausgangslichtstrahls (L1, ... bzw. L(n-1)) einen bestimmten, dieser folgenden Strahlumlenkungseinrichtung (2, ...bzw. n) zugeordneten Eckwinkel (α2, α3, ... αn) einschließt, und wobei
- jede Strahlumlenkungseinrichtung (1, 2, ...n) jeweils aus zumindest zwei aufeinanderfolgenden polarisationserhaltenden Strahlumlenkeinheiten (10, 30; 10, 20, 30) - wenigstens einer eingangsseitigen (10) und einer ausgangsseitigen (30) - besteht, deren jede
- aus einem dieser Strahlumlenkeinheit (10, 30; 10, 20, 30) in einer richtigen Ausbreitungsrichtung (r0, r1, ... rn, r12) zugeführten Lichtstrahl (L0, L1, ... L(n-1), L12) einen ersten umgelenkten Lichtstrahl (L11) erzeugt, der sich senkrecht zu diesem zugeführten Lichtstrahl (L0, L1, ... L(n-1), L12) ausbreitet, und
- aus diesem ersten umgelenkten Lichtstrahl (L11) einen zweiten umgelenkten Lichtstrahl (L12) erzeugt, der sich sowohl senkrecht zu diesem zugeführten Lichtstrahl (L0, L1, ... L(n-1), L12) als auch senkrecht zu diesem ersten umgelenkten Lichtstrahl (L11) ausbreitet, wobei eine bestimmte Polarisation (lin) des zugeführten Lichtstrahls (L0, L1, ... L(n-1), L12) im zweiten umgelenkten Lichtstrahl (L12) erhalten bleibt,
wobei
in jeder Strahlumlenkungseinrichtung (1, 2, ... n)
- der Eingangslichtstrahl (L0) oder Ausgangslichtstrahl (L1, ... bzw. L(n-1)), in welchem diese Strahlumlenkungseinrichtung (1, 2, ... n) angeordnet ist, und die eingangsseitige Strahlumlenkeinheit (10) dieser Strahlumlenkungseinrichtung (1, 2, ... n) derart relativ zueinander angeordnet sind, daß die Ausbreitungsrichtung (r0, r1, ... r(n-1)) des Eingangslichtstrahls (L0) oder Ausgangslichtstrahls (L1, ... bzw. L(n-1)) in bezug auf diese eingangsseitige Strahlumlenkeinheit (10) richtige Ausbreitungsrichtung ist, und
- jede auf eine Strahlumlenkeinheit (10; 10, 20) folgende Strahlumlenkeinheit (20; 20, 30) derart in dem von der vorhergehenden einen Strahlumlenkeinheit (10; 10, 20) erzeugten zweiten umgelenkten Lichtstrahl (L12) angeordnet ist, daß die Ausbreitungsrichtung (r12) dieses zweiten umgelenkten Lichtstrahls (L12) in bezug auf die folgende Strahlumlenkeinheit (20, 30) richtige Ausbreitungsrichtung ist,
wobei
- jede Strahlumlenkungseinrichtung (1, 2, ...n) zumindest eine von der ausgangsseitigen Strahlumlenkeinheit (30) verschiedene Strahlumlenkeinheit (10; 10, 20) aufweist, bei welcher der von ihr erzeugte zweite umgelenkte Lichtstrahl (L12) eine Strahllängsachse (120) aufweist, längs der sich dieser umgelenkte Lichtstrahl (L12) ausbreitet und um welche eine folgende Strahlumlenkeinheit (20; 20, 30), der dieser umgelenkte Lichtstrahl (L12) zugeführt ist, drehbar ist, ohne daß die richtige Ausbreitungsrichtung (r12) dieses umgelenkten Lichtstrahls (L12) in bezug auf die folgende Strahlumlenkeinheit (20; 20, 30) verlassen wird, und
wobei
- die ausgangsseitige Strahlumlenkeinheit (30) jeder Strahlumlenkungseinrichtung (1, 2, ... bzw. n) einen zweiten umgelenkten Lichtstrahl (L12) erzeugt, dessen Ausbreitungsrichtung (r12) aufgrund der Drehbarkeit einer Strahlumlenkeinheit (20; 20, 30) um eine Strahllängsachse (120) auf einen dieser Strahlumlenkungseinrichtung (1, 2, ...n) zugeordneten Eckwinkel ((α1, α2,... bzw. αn)) eingestellbar ist und der den Ausgangslichtstrahl (L1, L2, ... bzw. Ln) dieser Strahlumlenkungseinrichtung (1, 2, ...n) bildet.

2. Anordnung nach Anspruch 1, wobei
- der n-eckige Lichtstrahl (L) eine bestimmte Achse (A) umgibt und
- sich der Eingangslichtstrahl (L0) und jeder von einer Strahlumlenkungseinrichtung (1, 2, ... bzw. n) erzeugte Ausgangslichtstrahl (L1, L2, ... Ln) jeweils in einer Ausbreitungsrichtung (r0, r1, r2, ... bzw. rn) quer zur Achse (A) ausbreitet.

3. Anordnung nach Anspruch 1 oder 2 , wobei
die Ausbreitungsrichtung (rn) des von der letzten Strahlumlenkungseinrichtung (n) erzeugten letzten umgelenkten Ausgangslichtstrahls (Ln) mit der Ausbreitungsrichtung (r0) des Eingangslichtstrahls (L0) einen zusätzlichen Eckwinkel (α(n+1)) einschließt.

4. Anordnung nach Anspruch 1 oder 2, wobei
- die Ausbreitungsrichtungen (r0, r1, r2, ... bzw. rn) des Eingangslichtstrahls (L0) und der Ausgangslichtstrahlen (L1, L2, ... Ln) sämtlicher Strahlumlenkungseinrichtungen (1, 2, ... n) jeweils parallel zu einer sämtlichen Strahlumlenkungseinrichtungen (1, 2, ... n) gemeinsamen Ebene (E) sind, wobei
- jede Strahllängsachse (120) längs der sich ein von einer Strahlumlenkeinrichtung (10; 10, 20) erzeugter zweiter umgelenkter Lichtstrahl (L12) ausbreitet und um welche die folgende Strahlumlenkeinheit (20; 20, 30) drehbar ist, senkrecht zur gemeinsamen Ebene (E) ist und wobei
- der von der ausgangsseitigen Strahlumlenkeinheit (30) jeder Strahlumlenkungseinrichtung (1, 2, ... bzw. n) erzeugte zweite umgelenkte Lichtstrahl (L12) parallel zur gemeinsamen Ebene (E) ist.

5. Anordnung nach Anspruch 4, bestehend aus drei Strahlumlenkungseinrichtungen (1, 2, 3), wobei
jede Strahlumlenkungseinrichtung (1, 2, 3) jeweils aus drei Strahlumlenkeinheiten - der eingangsseitigen Strahlumlenkeinheit (10), der ausgangsseitigen Strahlumlenkeinheit (30) und einer zwischen der eingangsseitigen und ausgangsseitigen Strahlumlenkeinheit (10, 30) angeordneten weiteren Strahlumlenkeinheit (20) - besteht und wobei
in jeder Strahlumlenkungseinrichtung (1, 2 bzw. 3)
- jeweils eine (10, 30 bzw. 10) der beiden Strahlumlenkeinheiten (10, 30), die von der den zweiten umgelenkten Lichtstrahl (L12) mit der zur gemeinsamen Ebene (E) senkrechten Strahllängsachse (120) erzeugenden Strahlumlenkeinheit (20, 10 bzw. 20) verschieden sind, einen ersten umgelenkten Lichtstrahl (L11) mit einer zu dieser gemeinsamen Ebene (E) senkrechten Ausbreitungsrichtung (r11) erzeugt, die zur Ausbreitungsrichtung (r12) des zweiten umgelenkten Lichtstrahls (L12) mit der zur gemeinsamen Ebene (E) senkrechten Strahllängsachse (120) entgegengesetzt ist und die Kompensation eines senkrecht zur gemeinsamen Ebene (E) bewirkten Versatzes (ε) des von der ausgangsseitigen Strahlumlenkeinheit (30) erzeugten und zur gemeinsamen Ebene (E) parallelen zweiten umgelenkten Lichtsstrahls (L12) dieser Strahlumlenkungseinrichtung (1, 2 bzw. 3) ermöglicht, so daß sich dieser zweite umgelenkte Lichtsstrahl (L12), der den Ausgangangslichtstrahl (L1, L2 bzw. L3) dieser Strahlumlenkungseinrichtung (1, 2 bzw. 3) bildet, in der gemeinsamen Ebene (E) ausbreitet.

6. Anordnung nach einem der Ansprüche 3 bis 5,
wobei die allen Strahlumlenkungseinrichtungen (1, 2, 3) gemeinsame Ebene (E) senkrecht zur Achse (A) ist.

7. Anordnung nach einem der vorhergehenden Ansprüche,
wobei eine Strahlumlenkeinheit (10, 20, 30)
- eine erste und zweite Reflexionsfläche (11, 12) aufweist, die derart relativ zueinander angeordnet sind, daß die erste Reflexionsfläche (11) beim Zuführen eines Lichtsrahls (L0, L1, ... L(n-1), L12) in der richtigen Ausbreitungsrichtung (r0, r1, ... r(n-1), r12) den ersten umgelenkten Lichtstrahl (L11) erzeugt, dessen Ausbreitungsrichtung r11 zur Ausbreitungsrichtung (r0, r1, ... r(n-1), r12) des zugeführten Lichtstrahls (L0, L1, ... L(n-1), L12) senkrecht ist, und daß die die zweite Reflexionsfläche (12) in dem den ersten umgelenkten Lichtstrahl (L11) angeordnet ist und aus diesem umgelenkten Lichtstrahl (L11) den zweiten umgelenkten Lichtstrahl (L12) erzeugt, dessen Ausbreitungsrichtung (r12) senkrecht zur Ausbreitungsrichtung (r0, r1, ... r(n-1), r12) des der ersten Reflexionsfläche (11) zugeführten Lichtstrahls (L0, L1, ... L(n-1), L12) und senkrecht zur Ausbreitungsrichtung (r11) des von der ersten Reflexionsfläche (11) erzeugten ersten umgelenkten Lichtstrahls (L11) ist.

8. Anwendung einer Anordnung nach einem der vorhergehenden Ansprüche bei einem Sensor zur elektro- und/oder magnetooptischen Messung der Stromstärke eines in einem elektrischen Leiter (50) geführten elektrischen Stroms und/oder einer am Leiter (50) anliegenden elektrischen Spannung mit Hilfe eines den Leiter (50) umgebenden und eine bestimmte Polarisation aufweisenden Lichtstrahls (L) zur Erzeugung dieses umgebenden Lichtstrahls (L).
